(19) Europäisches Patentamt
European Patent Office
Office européen des brevets

(11) **EP 1 376 148 B1**

(12) **EUROPÄISCHE PATENTSCHRIFT**

(45) Veröffentlichungstag und Bekanntmachung des Hinweises auf die Patenterteilung:
**21.10.2009 Patentblatt 2009/43**

(51) Int Cl.:
*G01R 33/3815* (2006.01) *G01R 33/421* (2006.01)

(21) Anmeldenummer: **03010065.5**

(22) Anmeldetag: **03.05.2003**

(54) **Verfahren zum Betrieb einer aktiv abgeschirmten Magnetanordnung**

Method for operating an actively shielded magnet arrangement

Procédé pour faire fonctionner un assemblage d'aimants blindé activement

(84) Benannte Vertragsstaaten:
**CH DE FR GB LI**

(30) Priorität: **22.06.2002 DE 10227876**

(43) Veröffentlichungstag der Anmeldung:
**02.01.2004 Patentblatt 2004/01**

(73) Patentinhaber: **Bruker BioSpin AG**
**8117 Fällanden (CH)**

(72) Erfinder:
• **Amann, Andreas**
**8008 Zürich (CH)**
• **Schauwecker, Robert**
**8004 Zürich (CH)**
• **Bovier, Pierre-Alain**
**8051 Zürich (CH)**

(74) Vertreter: **Kohler Schmid Möbus**
**Patentanwälte**
**Ruppmannstraße 27**
**70565 Stuttgart (DE)**

(56) Entgegenhaltungen:
**EP-A- 0 468 415 EP-A- 1 182 463**
**EP-A- 1 213 591**

**Beschreibung**

Die Erfindung betrifft ein Verfahren zum Betrieb einer Magnetanordnung mit einem aktiv abgeschirmten, supraleitenden Magnetspulensystem und mit mindestens einem, im Betriebszustand in sich supraleitend geschlossenen Strompfad eines zusätzlichen Spulensystems, wobei das aktiv abgeschirmte, supraleitende Magnetspulensystem ein radial inneres Teilspulensystem und ein radial äußeres Teilspulensystem umfaßt, welche zueinander koaxial angeordnet sind und deren magnetische Dipolmomente im Betriebszustand entgegengesetzte Vorzeichen aufweisen und sich betragsmäßig um $\Delta_m$ voneinander unterscheiden mit $|\Delta_m| < 2.5\%$ des Betrags des magnetischen Dipolmoments des radial inneren Teilspulensystems.

Eine solche Magnetanordnung mit einem aktiv abgeschirmten Magnetspulensystem und mit mindestens einem zusätzlichen, supraleitend geschlossenen Strompfad ist bekannt aus der Patentschrift US 6,265,960. In dieser Magnetanordnung wirkt ein zusätzlicher, supraleitend geschlossener Strompfad als supraleitende Shimvorrichtung zur Verbesserung der Feldhomogenität im Arbeitsvolumen der Magnetanordnung.

Eine weitere Magnetanordnung mit einem aktiv abgeschirmten Magnetspulensystem und mit mindestens einem zusätzlichen, supraleitend geschlossenen Strompfad ist bekannt aus der Patentschrift WO 00/52490. In dieser Magnetanordnung wirkt ein zusätzlicher, supraleitend geschlossener Strompfad als Vorrichtung zur Kompensation von externen elektromagnetischen Störungen, als Vorrichtung zur Kompensation einer vom Magnetspulensystem selbst verursachten Felddrift oder als Vorrichtung zur Feinanpassung der magnetischen Feldstärke im Arbeitsvolumen.

Die EP 1 213 591 A2 beschreibt eine Magnetanordnung mit einem aktiv abgeschirmten, supraleitenden Magnetspulensystem und einem zusätzlichen Strompfad zur Streufeldunterdrückung im Quenchfall. Gemäß dem Prinzip der Erhaltung des magnetischen Flusses fließen im Quenchfall Kompensationsströme im zusätzlichen Strompfad, die das Streufeld stabilisieren.

Das Einsatzgebiet von supraleitenden Magneten umfaßt verschiedene Anwendungsfelder. Dazu gehören insbesondere Hochfeldanwendungen, beispielsweise für Magnetresonanzverfahren. Solche Hochfeldmagneten erzeugen typischerweise auch ein beträchtliches Streufeld, was für die Umgebung des Magneten ein Gefahrenpotential darstellt. Diesem Problem kann begegnet werden, indem der Magnet mit einer aktiven Abschirmung ausgerüstet wird, also mit einer zusätzlichen supraleitenden Spule, welche mit der Hauptspule des Magneten in Serie geschaltet ist, aber ein Feld mit entgegengesetzter Polarität erzeugt.

Insbesondere für Magneten mit sehr effizienter Streufeldabschirmung ergibt sich das Problem, dass Abweichungen von den Designvorgaben für die Magnetspulen eine beträchtliche Veränderung des von der Magnetanordnung erzeugten Streufeldes zur Folge haben können, so dass spezifizierte Streufeldgrenzwerte verletzt werden. Geringe Abweichungen von den Designvorgaben aufgrund von Fertigungstoleranzen sind unvermeidbar. Beispielsweise können die Drahtdurchmesser Schwankungen bis zur Größenordnung eines Prozents aufweisen. Dass sich solch kleine Abweichungen in einer dramatischen Verschlechterung der Streufeldwerte auswirken können, rührt daher, dass zur Kompensation des Streufeldes außerhalb der Magnetanordnung große Feldbeiträge mit unterschiedlichem Vorzeichen einander überlagert werden . An einem Ort, wo ein Streufeld von 0.5mT resultieren soll, liegen die sich gegenseitig kompensierenden Beiträge von Hauptspule und Streufeldabschirmung beispielsweise in der Größenordnung von 100mT. Wenn nun einer dieser beiden Feldbeiträge aufgrund der begrenzten Fertigungsgenauigkeit der Spulensysteme um ca. 1% von seinem Sollwert abweicht, führt dies am Ort der 0.5mT-Isofeldfläche zu einer Abweichung der Streufeldstärke von ca. 1 mT vom Sollwert. Das spezifizierte Streufeldlimit an diesem Ort könnte in einem solchen Fall also um ein Mehrfaches überschritten werden.

Aufgabe der vorliegenden Erfindung ist es, ein Verfahren gemäß Stand der Technik derart zu verbessern, dass ihre Streufeldgrenzwerte auch dann eingehalten werden, wenn einzelne Parameter der Spulenanordnung aufgrund der begrenzten Fertigungsgenauigkeit von den Sollwerten abweichen. Hierbei sollen insbesondere die Streufeldauswirkungen von Abweichungen der Wickeldaten vom Sollwert und Abweichungen der Geometrie der Spulenkörper, welche als Träger der einzelnen Spulensysteme dienen, von ihrer Sollgeometrie kompensiert werden.

Erfindungsgemäß wird diese Aufgabe durch die Merkmale des kennzeichnenden Teils von Anspruch 1 gelöst. Insbesondere können sich ein oder mehrere zusätzliche Strompfade beim Laden des aktiv abgeschirmten Magnetspulensystems induktiv aufladen. Dazu werden diese Strompfade bereits während des Ladevorganges des aktiv abgeschirmten Magnetspulensystems supraleitend geschlossen. Die zusätzlichen Strompfade werden so ausgelegt, dass der beim Laden des aktiv abgeschirmten Magnetspulensystems in ihnen induzierte Strom davon abhängt, um wieviel verschiedene Designparameter des Magnetspulensystems, wie Drahtwindungszahlen und Spulengeometrie, von ihrem Sollwert abweichen. Zusätzlich müssen die erfindungsgemäßen, induktiv geladenen Strompfade eine genügend große Flächenwindungszahl aufweisen, damit der in ihnen induzierte Strom einen ausreichend großen Streufeldbeitrag, insbesondere ein magnetisches Dipolmoment, erzeugen kann. Unter diesen Bedingungen kann im Betriebszustand der Anordnung mindestens ein Teil einer allfälligen, fertigungsbedingten Abweichung des magnetischen Dipolmomentes des aktiv abgeschirmten Magnetspulensystems von seinem Sollwert durch das Dipolmoment des in den zusätzlichen, supraleitend kurzgeschlossenen Strompfaden induzierten Stromes kompensiert werden.

Der Vorteil eines erfindungsgemäßen Verfahrens besteht darin, dass auch bei sehr gut aktiv abgeschirmten supraleitenden Magnetsystemen, deren Streufeld besonders stark auf Abweichungen der Designparameter der Magnetspulenanordnung von ihren Sollwerten reagiert, die theoretisch erreichbaren Streufeldlimiten eingehalten werden können, ohne dass kostspielige und aufwendige Maßnahmen getroffen werden müßten, um produktionstechnisch bedingte Abweichungen von den Designvorgaben zu verhindern. Dies erlaubt eine kostengünstigere Produktion, da während des Fertigungsprozesses keine zusätzlichen Vorkehrungen zur exakten Einhaltung der Wickeldaten gemäß Designvorgaben nötig sind und keine besonders eng tolerierten Drähte und Spulenkörper verwendet werden müssen. Besonders vorteilhaft am erfindungsgemäßen Verfahren ist, dass es Streufeldgrenzwertüberschreitungen aufgrund von Abweichungen unterschiedlicher Designparameter des aktiv abgeschirmten Magnetspulensystems von ihren Sollwerten verhindern kann, ohne dass für jeden einzelnen Parameter eine spezielle Anordnung berechnet und konstruiert werden müßte. Insbesondere können mit einem erfindungsgemäßen Verfahren allfällige Überschreitungen der Streufeldgrenzwerte der Magnetanordnung aufgrund von Fertigungsungenauigkeiten ohne weitere Verfahrensschritte bei der Systeminstallation verhindert werden.

Von den zusätzlichen, supraleitend kurzgeschlossenen Strompfaden weist mindestens einer mit dem radial inneren Teilspulensystem und mindestens einer mit dem radial äußeren Teilspulensystem des aktiv abgeschirmten, supraleitenden Magnetspulensystems eine von Null verschiedene induktive Kopplung auf. Ohne diese Bedingung kann eine Abweichung der Designparameter der Teilspulensysteme von ihren Sollwerten von den zusätzlichen, supraleitend kurzgeschlossenen Strompfaden unbemerkt bleiben. Dies bedeutet, dass die Streufeldabweichung aufgrund einer Abweichung der Designparameter der Teilspulensysteme von ihren Sollwerten unkompensiert bliebe.

Eine besonders bevorzugte Ausführungsform des erfindungsgemäßen Verfahrens zeichnet sich dadurch aus, dass mindestens einer der zusätzlichen, supraleitend kurzgeschlossenen Strompfade vom Magnetspulensystem insgesamt induktiv entkoppelt ist, sofern keine Abweichungen von den Designvorgaben vorhanden sind. Dies wird vorzugsweise dadurch erreicht, dass für jeden dieser Strompfade die nicht verschwindende induktive Kopplung mit dem radial inneren Teilspulensystem im Wesentlichen entgegengesetzt gleich der induktiven Kopplung mit dem radial äußeren Teilspulensystem ist. Dies hat den Vorteil, dass für ein System, welches genau den Designvorgaben entspricht, kein Strom in diese zusätzlichen Strompfade induziert wird. Falls aber in einem der beiden Teilspulensysteme eine fertigungsbedingte Abweichung eines Designparameters von seinem Sollwert auftritt, resultiert eine induktive Kopplung zwischen dem Magnetspulensystem und diesen Strompfaden. Der beim Laden des Magnetspulensystems dadurch in diesen Strompfaden induzierte Strom baut ein Magnetfeld auf, welches die Abweichung des magnetischen Flusses der Magnetanordnung vom Designwert kompensiert. Diese Bedingung ist notwendig dafür, dass auch die fertigungsbedingte Abweichung des Streufeldes der Magnetanordnung von seinem Sollwert kompensiert wird.

Das erfindungsgemäße Verfahren ist besonders dann vorteilhaft, wenn sich die magnetischen Dipolmomente der Teilspulensysteme des aktiv abgeschirmten Magnetspulensystems betragsmäßig um weniger als 1% des Betrags des magnetischen Dipolmoments des radial inneren Teilspulensystems unterscheiden. In diesem Fall sind die fertigungsbedingten Abweichungen der Dipolmomente der beiden Teilspulensysteme des aktiv abgeschirmten Magnetspulensystems in Relation zum Gesamtdipolmoment des Magnetspulensystems besonders groß. Dies führt zu großen Abweichungen des Gesamtdipolmoments des Magnetspulensystems von seinem theoretischen Wert schon aufgrund kleiner Abweichungen von Designparametern der Teilspulensysteme von ihren Sollwerten. Somit ist es insbesondere für solche aktiv abgeschirmte Magnetspulensysteme vorteilhaft, wenn eine Vorrichtung in der Form zusätzlicher supraleitend kurzgeschlossener Strompfade zur Kompensation von Abweichungen des Streufeldes des Magnetspulensystems von seinem Sollwert vorhanden ist.

Besonders vorteilhaft ist auch eine Ausführungsform des erfindungsgemäßen Verfahrens, bei dem die Magnetanordnung Teil einer Apparatur zur hochauflösenden Magnetresonanzspektroskopie ist. Da für solche Magnetanordnungen das radial innere Teilspulensystem aufgrund der für solche Apparaturen benötigten hohen Feldstärken im Allgemeinen ein sehr großes Dipolmoment aufweist, bringt der Einsatz aktiv abgeschirmter Magnetsysteme hier einen besonders großen Gewinn. In einem erfindungsgemäßen Verfahren ist gewährleistet, dass auch bei fertigungstechnisch bedingten Abweichungen des Magnetspulensystems von dessen Designvorgaben keine Streufeldüberhöhung auftritt, da eine solche aufgrund des typischerweise großen Dipolmomentes der Hauptspule in diesem Fall besonders unerwünscht wäre.

Vorteilhaft ist auch eine Ausführungsform des erfindungsgemäßen Verfahrens, bei dem mindestens einer der zusätzlichen, supraleitend kurzgeschlossenen Strompfade eine Vorrichtung zur Begrenzung des in ihm induzierten Stromes aufweist. Dies verhindert, dass beim Laden des aktiv abgeschirmten Magnetspulensystems ein derart großer Strom in den zusätzlichen Strompfad induziert wird, dass dieser beschädigt werden könnte.

Besonders bevorzugt ist eine Ausführungsform des erfindungsgemäßen Verfahrens, in welcher in mindestens einem der zusätzlichen, supraleitend geschlossenen Strompfade ein supraleitender Schalter integriert ist und wobei die Magnetanordnung eine Vorrichtung zur Stromspeisung dieses Strompfades umfaßt. Dies erlaubt eine Feinabstimmung des von der gesamten Magnetanordnung erzeugten Streufeldes, indem der Strom in diesem zusätzlichen Strompfad wunschgemäß angepaßt werden kann. Insbesondere für spezielle Anwendungen und Örtlichkeiten lassen sich so für eine erfindungsgemäßes Verfahren auch von den Designwerten abweichende Streufeldgeometrien erreichen, ohne dass hierzu zusätzliche Mittel vonnöten wären.

Eine weitere vorteilhafte Ausführungsform des erfindungsgemäßen Verfahrens zeichnet sich dadurch aus, dass mindestens einer der zusätzlichen, supraleitend kurzgeschlossenen Strompfade Teil einer Vorrichtung ist, welche der Magnetanordnung zusätzliche Funktionalität verleiht, insbesondere, dass dieser Strompfad zur Kompensation von externen magnetischen Feldfluktuationen dient. Der Vorteil dieser Ausführungsform liegt darin, dass durch diese Doppelfunktionalität die gesamte Magnetanordnung kompakter gestaltet werden kann.

Eine weitere besonders bevorzugte Ausführungsform des erfindungsgemäßen Verfahrens zeichnet sich dadurch aus, dass mindestens einer der zusätzlichen, supraleitend kurzgeschlossenen Strompfade vom aktiv abgeschirmten Magnetspulensystem thermisch entkoppelt ist. Dies bewirkt, dass im Falle eines Quenchs im Magnetspulensystem die an diesen zusätzlichen Strompfad übertragene Wärmemenge mindestens kurzfristig zu klein ist, um in diesem zusätzlichen Strompfad einen Quench auszulösen. Dieser Umstand ist notwendig dafür, dass aufgrund der Änderung des magnetischen Flusses in der Anfangsphase des Quenchs des Magnetspulensystems ein Strom in den zusätzlichen noch supraleitenden Strompfad induziert werden kann, was eine Voraussetzung dafür ist, dass das Streufeld der Magnetanordnung auch während des Quenchs nicht überhöht wird.

Besonders bevorzugt ist auch eine Ausführungsform des erfindungsgemäßen Verfahrens, bei welcher mindestens einer der zusätzlichen, supraleitend geschlossenen Strompfade Magnetspulen umfaßt, welche einen Radius haben, der mindestens 90% des Radius der äußersten Spulen des aktiv abgeschirmten, supraleitenden Magnetspulensystems beträgt. Da dieser Strompfad eine große Fläche umschließt, erzeugt er ein beträchtliches magnetisches Dipolmoment, ohne dass ein großer Strom in ihm fließen müßte. Dies ist vorteilhaft, weil so der maximal fließende Strom in diesem Strompfad ohne Weiteres deutlich unter dem kritischen Strom, oberhalb welchem die Supraleitung zusammenbrechen würde, gehalten werden kann.

Eine weitere vorteilhafte Ausführungsform des erfindungsgemäßen Verfahrens zeichnet sich dadurch aus, dass mindestens einer der zusätzlichen, supraleitend geschlossenen Strompfade Spulen umfaßt, welche auf einem Spulenkörper gewickelt sind, der auch Spulen des äußeren Teilspulensystems des aktiv abgeschirmten, supraleitenden Magnetspulensystems als Träger dient. Dadurch wird erreicht, dass dieser zusätzliche Strompfad eine große Fläche umschließt und somit bereits bei kleinem induzierten Strom ein magnetisches Dipolmoment erzeugt, welches einen ausreichenden Einfluß auf das Streufeld besitzt. Weil für diesen zusätzlichen Strompfad kein zusätzlicher Spulenkörper hergestellt werden muss, wird die Herstellung der Magnetanordnung günstiger.

Eine weitere bevorzugte Ausführungsform des erfindungsgemäßen Verfahrens zeichnet sich dadurch aus, dass mindestens einer der zusätzlichen, supraleitend geschlossenen Strompfade im Betriebszustand bezüglich der Ebene, welche senkrecht zur $z$-Achse liegt und diese bei $z = 0$ schneidet, ein asymmetrisches Magnetfeld erzeugt. In einer solchen Ausführungsform können auch bezüglich dieser Ebene asymmetrische Abweichungen des Streufeldes der Magnetanordnung von seinem Sollverlauf korrigiert werden. Solche Streufeldverzerrungen können beispielsweise durch supraleitende Shimspulen in der Magnetanordnung hervorgerufen werden, sofern die Shimspulen einen Feldbeitrag leisten, der auf der $z$-Achse um $z = 0$ in ein Polynom in $z$ mit ungeraden Koeffizienten $Hn$ entwickelt werden kann.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fig. 1   einen schematischen Vertikalschnitt durch eine radiale Hälfte der Magnetanordnung, welche im erfindungsgemäßen Verfahren Verwendung findet;

Fig. 2   ein Verdrahtungsschema einer im erfindungsgemäßen Verfahren verwendeten Magnetanordnung.

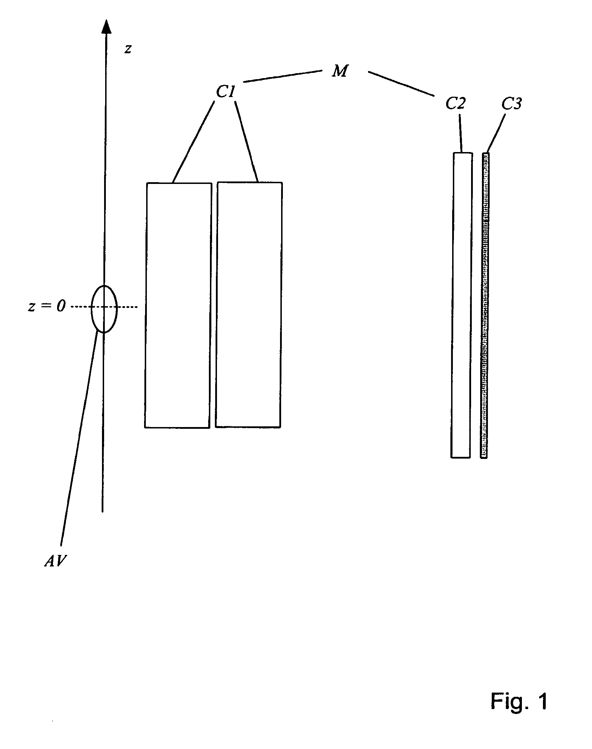

Anhand der Figur 1 wird eine Magnetanordnung gezeigt, welche um ein Arbeitsvolumen $AV$ angeordnet ist und ein aktiv abgeschirmtes, supraleitendes Magnetspulensystem $M$ mit einem radial inneren und einem radial äußeren, koaxialen Teilspulensystem $C1$ und $C2$ sowie einen zusätzlichen, supraleitend geschlossenen Strompfad $P1$ in Form eines zusätzlichen Spulensystems $C3$ umfaßt.

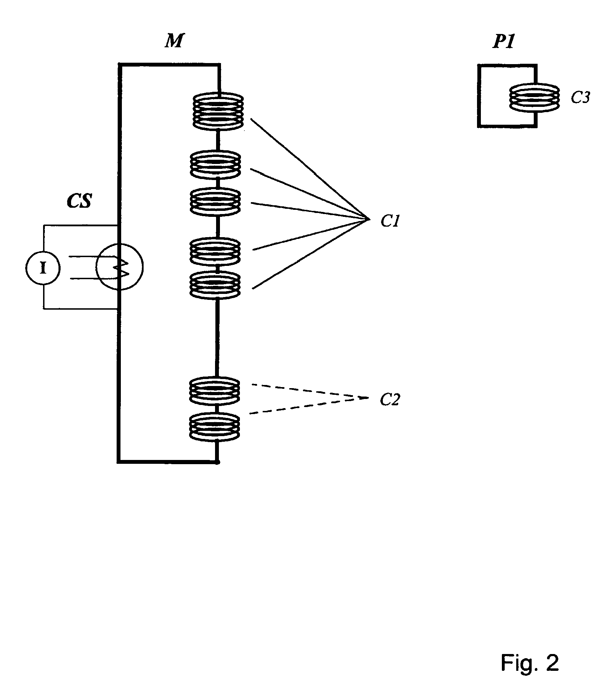

Figur 2 zeigt schematisch die Verdrahtung einer Magnetanordnung, insbesondere den zusätzlichen, supraleitend geschlossenen Strompfad $P1$ in der Ausführungsform eines vom aktiv abgeschirmten, supraleitenden Magnetspulensystem $M$ getrennten zusätzlichen Spulensystems $C3$. Das Magnetspulensystem M verfügt über eine externe Stromspeisung $CS$.

Im Folgenden wird die Erfindung anhand von zwei Beispielen einer Magnetanordnung mit einem aktiv abgeschirmten, supraleitenden Magnetspulensystem erläutert, welche im Arbeitsvolumen $AV$ je ein Magnetfeld der Stärke 9T erzeugen. Als Supraleitermaterial wird Niob-Titan eingesetzt. Die Magnetanordnung wird in einem Flüssighelium-Bad betrieben bei einer Temperatur von 4.2K.

Die erste Magnetanordnung (im Weiteren Beispiel "*V1*" genannt) umfaßt ein aktiv abgeschirmtes, supraleitendes Magnetspulensystem M gemäß dem aktuellen Stand der Technik. Ein radial inneres Teilspulensystem *C1* und ein radial äußeres Teilspulensystem *C2* sind Teil dieses Magnetspulensystems. Hierbei besteht *C1* aus zwei, direkt aufeinander gewickelten, konzentrischen und koaxialen Solenoidspulen *C1a* und *C1b* welche die gleiche Polarität aufweisen, und *C2* besteht aus einer einzelnen, zu *C1* konzentrisch und koaxial angeordneten Solenoidspule mit zu *C1* entgegengesetzter Polarität. Der Betriebsstrom für dieses Magnetspulensystem beträgt 81.7A, die freie Innenbohrung hat einen Durchmesser von 70mm.

Mit der Variante V1 wird eine Variante (im Weiteren "*V2*" genannt) verglichen, welche neben dem Magnetspulensystem *M einen* zusätzlichen, supraleitend geschlossenen Strompfad *P1* in Form eines weiteren Spulensystems *C3* umfaßt. Im vorliegenden Beispiel ist das Magnetspulensystem *M* identisch mit demjenigen der Variante *V1* und *C3* besteht aus einer zweilagigen Solenoidspule, welche direkt auf die äußerste Lage von *C2* gewickelt wurde.

Tabelle 1 zeigt die wichtigsten Merkmale der Teilspulensysteme *C1 (C1a* und C1b) und C2 sowie des zusätzlichen Magnetspulensystems C3.

**Tabelle 1**

| | *C1a* | *C1b* | *C2* | *C3* |
|---|---|---|---|---|
| *ri* [mm] | 38.0 | 58.5 | 222.0 | 225.4 |
| *ra* [mm] | 58.5 | 102.2 | 225.4 | 226.6 |
| *L* [mm] | 380 | 380 | 450 | 287 |
| *W* | 361 | 468 | 698 | 445 |
| *N* | 26 | 62 | 6 | 2 |
| *m\** [m²] | 673.4 | | -658.7 | 143.0 |
| | 14.7 | | | |

In der Tabelle 1 bezeichnen:

*ri* den Innenradius der Solenoidspule,
*ra* den Außenradius der Solenoidspule,
*L* die Länge der Solenoidspule,
*W* die Anzahl Draht-Windungen auf jeder Lage der Solenoidspule,
*N* die Anzahl Drahtlagen der Solenoidspule,
*m\** das magnetische Dipolmoment pro Ampère Strom.

Im Folgenden soll nun für die Magnetanordnungen V1 beziehungsweise V2 der Einfluß von Abweichungen von den Designvorgaben in einzelnen Magnetspulen auf das Streufeld der Anordnung im Betriebszustand berechnet werden. Als Beispiel für eine mögliche Abweichung eines Designparameters von seinem Sollwert dient hier eine Zunahme der Drahtwindungen im Teilspulensystem C2 gegenüber dem theoretischen Wert aufgrund eines gegenüber seinem Sollwert verminderten Durchmessers des Supraleiterdrahtes.

Zur Berechnung des in *C3* induzierten Stromes benötigen wir die Induktivitätsmatrix der beschriebenen Anordnung. Diese berechnet sich für eine Anordnung, welche exakt nach den Designvorgaben für die Beispiele *V1* beziehungsweise *V2* produziert wurde, zu

$$L_{Design} = \begin{bmatrix} L_{C1} & L_{C1 \leftrightarrow C2} & L_{C1 \leftrightarrow C3} \\ L_{C1 \leftrightarrow C2} & L_{C2} & L_{C2 \leftrightarrow C3} \\ L_{C1 \leftrightarrow C3} & L_{C2 \leftrightarrow C3} & L_{C3} \end{bmatrix} = \begin{bmatrix} 51.67H & -5.15H & 1.21H \\ -5.15H & 5.28H & -1.21H \\ 1.21H & -1.21H & 0.32H \end{bmatrix} ,$$

wobei die Matrixelemente, welche Kopplungen mit *C3* beschreiben, nur für die Ausführungsform *V2* relevant sind. Wie sich aus den obigen Werten erkennen läßt, ist in der Ausführungsform *V2* gemäß Designvorgaben das Magnetspulensystem *M vom* Magnetspulensystem *C3* insgesamt induktiv entkoppelt $(L_{C1 \leftrightarrow C3} + L_{C2 \leftrightarrow C3} = 0)$, *C3* weist jedoch jeweils mit den Teilspulensystemen $C1$ und $C2$ einzeln eine relativ starke Kopplung auf.

Das Magnetspulensystem $M$ weist ein Streufeld auf, welches beispielsweise durch die maximale Ausdehnung der 0.5mT Isofeldfläche charakterisiert werden kann. In einer Ausführung des Magnetspulensystems $M$ gemäß Designvorgaben beträgt diese Ausdehnung 0.63m in radialer und 1.09m in axialer Richtung. Wird nun beispielsweise im Teilspulensystem C2 ein Draht verwendet, welcher verglichen mit den spezifizierten Werten einen um 4% kleineren Durchmesser aufweist, so dass dieses Teilspulensystem 727 statt 698 Windungen pro Lage umfaßt, so wird die radiale Ausdehnung der 0.5mT Isofeldfläche für die Variante $V1$ deutlich vergrößert. Dies wird in der im erfindungsgemäßen Verfahren verwendeten Magnetanordnung $V2$ dadurch behoben, dass im zusätzlichen Magnetspulensystem $C3$ aufgrund der gegenüber dem Designwert geänderten induktiven Kopplung mit dem Teilspulensystem $C2$ ein Strom induziert wird, welcher die Abweichung des Streufelds vom Sollwert praktisch vollständig kompensiert. Die zusätzlichen Drahtwindungen im Teilspulensystem $C2$ bewirken eine Verstärkung der induktiven Kopplung $L_{C2 \leftrightarrow C3}$ auf -1.26H. Dadurch ist das Magnetspulensystem $C3$ insgesamt nicht mehr vom Magnetspulensystem $M$ induktiv entkoppelt. Durch das Laden des Magnetspulensystems $M$ auf dessen Sollstrom (welcher aufgrund der höheren Windungszahl in $C2$ neu 82.0A beträgt) wird durch diese induktive Kopplung in das Magnetspulensystem $C3$ ein Strom von 12.5A induziert.

Tabelle 2 zeigt die resultierenden Dipolmomente im Betriebszustand und die Abmessungen der 0.5mT Isofeldfläche für die zwei Ausführungsformen $V1$ und $V2$ gemäß Designvorgaben sowie für einen um 4% zu dünnen Draht im Teilspulensystem $C2$.

**Tabelle 2**

| | gemäß Design | Wickelabweichungen in $C2$ | |
|---|---|---|---|
| | *V1 & V2* | *V1* | *V2* |
| $R5G$ [m] | 0.63 | 0.80 | 0.64 |
| $Z5G$ [m] | 1.09 | 0.92 | 1.05 |
| $B63$ [mT] | 0.50 | 1.26 | 0.55 |
| $m_{C1}$ [Am$^2$] | 55051 | 55225 | 55225 |
| $m_{C2}$ [Am$^2$] | -53850 | -56236 | -56236 |
| $m_M$ [Am$^2$] | 1201 | -1011 | -1011 |
| $m_{C3}$ [Am$^2$] | 0 | – | 1789 |

In der Tabelle 2 bezeichnen:

$R5G$ die maximale Ausdehnung der 0.5mT Isofeldfläche in radialer Richtung, gemessen ab der Magnetachse,

$Z5G$ die maximale Ausdehnung der 0.5mT Isofeldfläche in axialer Richtung, gemessen ab der Magnetmittelebene,

$B63$ den maximalen Betrag der Feldstärke der Magnetanordnung auf einer mit dem Magnetspulensystem koaxialen Zylinderfläche mit Radius 0.63m,

$m_{C1}$ das magnetische Dipolmoment des Teilspulensystems $C1$ im Betriebszustand,

$m_{C2}$ das magnetische Dipolmoment des Teilspulensystems $C2$ im Betriebszustand,

$m_M$ das magnetische Dipolmoment des Magnetspulensystems $M$ im Betriebszustand,

$m_{C3}$ das magnetische Dipolmoment des zusätzlichen Teilspulensystems $C3$ im Betriebszustand.

Wie man den Werten aus der Tabelle 2 entnehmen kann, bewirkt die Abweichung der Wickeldaten von den Designvorgaben eine deutliche Änderung des magnetischen Dipolmomentes des Teilspulensystems $C2$. In der erfindungsgemäßen Ausführungsform $V2$ wird diese Änderung weitgehend durch das magnetische Dipolmoment, welches von dem im Magnetspulensystem $C3$ induzierten Strom erzeugt wird, wieder wettgemacht, so dass ein gegenüber dem Design praktisch unverändertes Streufeld resultiert. Wie man ebenfalls der Tabelle 2 entnehmen kann, weist ein hinsichtlich minimaler radialer Ausdehnung der 0.5mT Isofeldfläche optimiertes Magnetspulensystem M kein minimales magnetisches Dipolmoment auf. Im Falle der angenommenen Windungszahlabweichungen im Teilspulensystem $C2$

resultiert für die Variante *V1* ein im Vergleich mit den Designvorgaben betragsmäßig kleineres magnetisches Dipolmoment, die Ausdehnung der 0.5mT Isofeldfläche in radialer Richtung ist jedoch deutlich größer als gemäß Designvorgaben. In der erfindungsgemäßen Ausführungsform *V2* wird durch den im zusätzlichen Spulensystem *C3* induzierten Strom die radiale Ausdehnung der 0.5mT Isofeldfläche wieder minimiert, obwohl das resultierende Gesamtdipolmoment dadurch betragsmäßig größer wird.

Der Bereich innerhalb des Abstandes *R5G* von der Magnetachse muß typischerweise von magnetfeldempfindlichen Geräten und magnetischen Materialien freigehalten werden. Für eine Anordnung gemäß Designvorgaben beträgt dieser Abstand 0.63m. Es ist daher entscheidend, dass die Feldstärke von 0.5mT ab diesem Abstand von der Magnetachse auch dann nicht überschritten wird, wenn einzelne Spulenparameter Werte aufweisen, welche vom Sollwert abweichen. Diese Forderung wird in der Ausführungsform *V1* nicht erfüllt. Das Streufeld kann im Abstand von 0.63m von der Magnetachse bis auf über das Doppelte des Designwertes von 0.5mT ansteigen und der Grenzwert von 0.5mT wird erst außerhalb eines Abstandes von 0.80m von der Magnetachse wieder unterschritten. Demgegenüber tritt in der erfindungsgemäßen Variante *V2* keine wesentliche Streufelderhöhung gegenüber den Designwerten auf.

Das Streufeld des Magnetspulensystems *M* im obigen Beispiel ist hinsichtlich einer minimalen radialen Ausdehnung der 0.5mT Isofeldfläche optimiert. Aufgrund von fertigungsbedingten Abweichungen einzelner Spulenparameter von ihren Designvorgaben kann in einer Ausführung der Magnetanordnung aus obigem Beispiel gemäß dem bisherigen Stand der Technik eine Reduktion der axialen Ausdehnung der 0.5mT Isofeldfläche gegenüber dem Sollwert resultieren. Dies geht aber immer mit einer Vergrößerung der radialen Ausdehnung der 0.5mT Isofeldfläche einher (wie aus dem in der Tabelle 2 gezeigten Beispiel ersichtlich ist). In einer erfindungsgemäßen Ausführung der Magnetanordnung wird dagegen der Einfluß von fertigungsbedingten Abweichungen einzelner Spulenparameter von ihren Designvorgaben auf das Streufeld weitgehend eliminiert. Somit können unabhängig von fertigungsbedingten Schwankungen gewisser Spulenparameter die im Design angestrebten Streufeldwerte der Magnetanordnung immer eingehalten werden. Mit einer erfindungsgemäßen Magnetanordnung kann also - unabhängig von fertigungsbedingten Schwankungen gewisser Spulen parameter - erreicht werden, dass das Streufeld der Anordnung im Betriebszustand immer hinsichtlich jener Kriterien optimiert ist, hinsichtlich welcher auch das Streufeld des aktiv abgeschirmten Magnetspulensystems im Design optimiert wurde.

**Patentansprüche**

1. Verfahren zum Betrieb einer Magnetanordnung zur Erzeugung eines Magnetfeldes *(H)* in Richtung einer *z*-Achse in einem auf der *z*-Achse um *z* = 0 angeordneten Arbeitsvolumen *(AV)* mit einem aktiv abgeschirmten, supraleitenden Magnetspulensystem *(M)* und mit mindestens einem, im Betriebszustand in sich supraleitend geschlossenen Strompfad *(P1, ..., Pn)* eines zusätzlichen Spulensystems *(C3)*, wobei das aktiv abgeschirmte, supraleitende Magnetspulensystem *(M)* ein radial inneres Teilspulensystem *(C1)* und ein radial äußeres Teilspulensystem *(C2)* umfasst, welche zueinander koaxial angeordnet sind und deren magnetische Dipolmomente im Betriebszustand entgegengesetzte Vorzeichen aufweisen und sich betragsmäßig um $\Delta_m$ voneinander unterscheiden mit $|\Delta_m| < 2.5\%$ des Betrags des magnetischen Dipolmoments des radial inneren Teilspulensystems *(C1)*,

   **dadurch gekennzeichnet,**

   **dass** von dem mindestens einen Strompfad *(P1, ..., Pn)* mindestens einer *(Pj$_1$, ..., Pj$_m$)* mit dem ersten, radial inneren Teilspulensystem *(C1)* und mindestens einer *(Pk$_1$, ..., Pk$_p$)* mit dem zweiten, radial äußeren Teilspulensystem *(C2)* des aktiv abgeschirmten, supraleitenden Magnetspulensystems *(M)* eine von Null verschiedene induktive Kopplung $L_{C1 \leftrightarrow Pj_1}, ..., L_{C1 \leftrightarrow Pj_m}$ beziehungsweise $L_{C2 \leftrightarrow Pk_1}, ..., L_{C2 \leftrightarrow Pk_p}$ aufweist, wobei $L_{C1}$, $L_{C2}$, $L_{Pj_1}, ..., L_{Pj_m}$ und $L_{Pk_1}, ..., L_{Pk_p}$ die Eigeninduktivitäten der Teilspulensysteme *(C1)* und *(C2)* des aktiv abgeschirmten, supraleitenden Magnetspulensystems *(M)* beziehungsweise die Eigeninduktivitäten der Strompfade *(Pj$_1$, ..., Pj$_m$)* und *(Pk$_1$, ..., Pk$_p$)* bezeichnen, dass der mindestens eine Strompfad *(P1, ..., Pn)* während des Ladens des aktiv abgeschirmten, supraleitenden Magnetspulensystems *(M)* mindestens zeitweise supraleitend kurzgeschlossen wird, wobei alle Strompfade *(P1, ..., Pn)* des mindestens einen Strompfades *(P1, ..., Pn)* so ausgelegt sind, dass die in ihnen aufgrund des Ladevorgangs des Magnetspulensystems *(M)* induzierten Ströme insgesamt ein magnetisches Dipolmoment erzeugen, dessen Betrag mindestens 0.1 % des Betrages des magnetischen Dipolmomentes des geladenen, radial äußeren Teilspulensystems *(C2)* erreicht, so dass der Streufeldverlauf außerhalb der Magnetanordnung optimiert wird.

2. Verfahren nach Anspruch 1, **dadurch gekennzeichnet, dass** die zugehörigen Kopplungskoeffizienten

$$K_{1,j_1} = \frac{L_{C1 \leftrightarrow Pj_1}}{\sqrt{L_{C1} L_{Pj_1}}}, ..., K_{1,j_m} = \frac{L_{C1 \leftrightarrow Pj_m}}{\sqrt{L_{C1} L_{Pj_m}}}$$

größer als 0.01 und

$$K_{2,k_1} = \frac{L_{C2 \leftrightarrow Pk_1}}{\sqrt{L_{C2} L_{Pk_1}}}, ..., K_{2,k_p} = \frac{L_{C2 \leftrightarrow Pk_p}}{\sqrt{L_{C2} L_{Pk_p}}}$$

kleiner als -0.01 sind.

3. Verfahren zum Betrieb einer Magnetanordnung nach einem der vorhergehenden Ansprüche, **dadurch gekennzeichnet, dass** bei der Auslegung der Teilspulensysteme *(C1)* und *(C2)* und des mindestens einen Strompfades *(P1, ..., Pn)* die Anzahl und Position der Drahtwindungen so gewählt wurden, dass von dem mindestens einen Strompfad *(P1, ..., Pn)* mindestens einer *(Pi_1, ..., Pi_q)* vom aktiv abgeschirmten, supraleitenden Magnetspulensystem *(M)* im Wesentlichen induktiv entkoppelt ist, insbesondere derart, dass für jeden dieser Strompfade *(Pi_1, ..., Pi_q)* die induktive Kopplung mit dem radial inneren Spulensystem *(C1)* im Wesentlichen entgegengesetzt gleich der induktiven Kopplung mit dem radial äußeren Spulensystem *(C2)* ist.

4. Verfahren zum Betrieb einer Magnetanordnung nach einem der vorhergehenden Ansprüche, **dadurch gekennzeichnet, dass** $|\Delta_m| < 1\%$ des Betrags des magnetischen Dipolmoments des radial inneren Teilspulensystems *(C1)* ist.

5. Verfahren zum Betrieb einer Magnetanordnung nach einem der vorhergehenden Ansprüche, **dadurch gekennzeichnet, dass** die Magnetanordnung Teil einer Apparatur zur hochauflösenden Magnetresonanzspektroskopie ist.

6. Verfahren zum Betrieb einer Magnetanordnung nach einem der vorangehenden Ansprüche, **dadurch gekennzeichnet, dass** von dem mindestens einen Strompfad *(P1, ..., Pn)* mindestens einer eine Vorrichtung zur Begrenzung des in ihm induzierten Stromes aufweist.

7. Verfahren zum Betrieb einer Magnetanordnung nach einem der vorangehenden Ansprüche, **dadurch gekennzeichnet, dass** von dem mindestens einen Strompfad *(P1, ..., Pn)* mindestens einer mit einem supraleitenden Schalter überbrückt ist und dass die Magnetanordnung eine Vorrichtung zur Stromspeisung dieses Strompfades umfasst.

8. Verfahren zum Betrieb einer Magnetanordnung nach einem der vorhergehenden Ansprüche, **dadurch gekennzeichnet, dass** von dem mindestens einen supraleitend kurzgeschlossenen Strompfad *(P1, ..., Pn)* mindestens einer zusätzlich Teil einer Vorrichtung ist, welche im Betriebszustand in der Magnetanordnung zur Kompensation externer magnetischer Feldfluktuationen dient.

9. Verfahren zum Betrieb einer Magnetanordnung nach einem der vorhergehenden Ansprüche, **dadurch gekennzeichnet, dass** von dem mindestens einen Strompfad *(P1, ..., Pn)* mindestens einer vom aktiv abgeschirmten, supraleitenden Magnetspulensystems *(M)* thermisch entkoppelt ist, vorzugsweise derart, dass die im Falle eines Quenchs des aktiv abgeschirmten, supraleitenden Magnetspulensystems *(M)* an diesen Strompfad übertragene Wärmemenge nicht mehr als fünfzig Prozent derjenigen Wärmemenge beträgt, welche zur Auslösung eines Quenchs in diesem Strompfad nötig ist.

10. Verfahren zum Betrieb einer Magnetanordnung nach einem der vorhergehenden Ansprüche, **dadurch gekennzeichnet, dass** von dem mindestens einen Strompfad *(P1, ..., Pn)* mindestens einer Magnetspulen umfasst, welche einen Radius haben, der mindestens 90% des Radius der äußersten Spulen des aktiv abgeschirmten, supraleitenden Magnetspulensystems *(M)* beträgt.

11. Verfahren zum Betrieb einer Magnetanordnung nach einem der vorhergehenden Ansprüche, **dadurch gekennzeichnet, dass** von dem mindestens einen Strompfad *(P1, ..., Pn)* mindestens einer Spulen umfasst, welche auf einem Spulenkörper gewickelt sind, der auch Spulen des radial äußeren Teilspulensystems *(C2)* des aktiv abgeschirmten, supraleitenden Magnetspulensystems (*M*) als Träger dient.

12. Verfahren zum Betrieb einer Magnetanordnung nach einem der vorhergehenden Ansprüche, **dadurch gekennzeichnet, dass** von dem mindestens einen Strompfad *(P1, ..., Pn)* mindestens einer im Betriebszustand bezüglich der Ebene, welche senkrecht zur *z*-Achse liegt und diese bei *z* = 0 schneidet, ein asymmetrisches Magnetfeld erzeugt.

**Claims**

1. Method for operating a magnet assembly for generating a magnetic field *(H)* in the direction of a z axis in a working volume *(AV)* disposed on the z axis about *z* = 0, comprising an actively shielded superconducting magnet coil system (*M*) and at least one current path (*P1, ..., Pn*) of an additional coil system (C3) which is superconductingly closed in the operating state, wherein the actively shielded superconducting magnet coil system (*M*) comprises a radially inner partial coil system (*C1*) and a radially outer partial coil system (*C2*) disposed coaxially with respect to each other and whose magnetic dipole moments in the operating state have opposite signs and differ by an amount $\Delta_m$, with $|\Delta_m| < 2.5\%$ of the magnitude of the magnetic dipole moment of the radially inner partial coil system *(C1)*, **characterized in**

   **that** of the at least one current path *(P1, ..., Pn)* at least one *(Pj$_1$, ..., Pj$_m$)* has a non-zero inductive coupling $L_{C1 \leftrightarrow Pj_1}$,..., $L_{C1 \leftrightarrow Pj_m}$ to the first radially inner partial coil system *(C1)* and at least one *(Pk$_1$, ..., Pk$_p$)* has a non-zero inductive coupling $L_{C2 \leftrightarrow Pj_1}$,...,$L_{C2 \leftrightarrow Pk_p}$ the second radially outer partial coil system *(C2)* of the actively shielded superconducting magnet coil system (M), wherein $L_{C1}$, $L_{C2}$, $L_{Pj_1}$,...,$L_{Pj_m}$ and $L_{Pk_1}$,...,$L_{Pk_p}$ designate the intrinsic inductances of the partial coil systems *(C1)* and *(C2)* of the actively shielded superconducting magnet coil system (*M*) and the intrinsic inductances of the current paths *(Pj$_1$, ..., Pj$_m$)* and *(Pk$_1$, ..., Pk$_p$)*, that the at least one current path *(P1, ..., Pn)* is at least temporally superconductingly short-circuited during charging of the actively shielded superconducting magnet coil system (M), wherein all current paths *(P1, ..., Pn)* of the at least one current path *(P1, ..., Pn)* are designed such that the currents induced therein due to the charging process of the magnet coil system (M) generate an overall magnetic dipole moment of a magnitude of at least 0.1% of the magnitude of the magnetic dipole moment of the charged radially outer partial coil system *(C2),* such that the stray field behavior outside of the magnet assembly is optimized.

2. Method according to claim 1, **characterized in that** the associated coupling coefficients

$$K_{1,j_1} = \frac{L_{C1 \leftrightarrow Pj_1}}{\sqrt{L_{C1} L_{Pj_1}}}, ..., K_{1,j_m} = \frac{L_{C1 \leftrightarrow Pj_m}}{\sqrt{L_{C1} L_{Pj_m}}}$$

are larger than 0.01 and

$$K_{2,k_1} = \frac{L_{C2 \leftrightarrow Pk_1}}{\sqrt{L_{C2} L_{Pk_1}}}, ..., K_{2,k_p} = \frac{L_{C2 \leftrightarrow Pk_p}}{\sqrt{L_{C2} L_{Pk_p}}}$$

are smaller than -0.01.

3. Method for operating a magnet assembly according to any one of the preceding claims, **characterized in that**, when the partial coil systems *(C1)* and *(C2)* and the at least one current path *(P1, ..., Pn)* are designed, the number and position of the wire windings is selected such that of the at least one current path *(P1, ..., Pn)* at least one *(Pi$_1$, ..., Pi$_q$)* is substantially inductively decoupled from the actively shielded superconducting magnet coil system (M), in particular such that for each of these current paths *(Pi$_1$, ..., Pi$_q$)* the inductive coupling to the radially inner coil system *(C1)* is substantially opposite and equal to the inductive coupling to the radially outer coil system *(C2)*.

4. Method for operating a magnet assembly according to any one of the preceding claims, **characterized in that** $|\Delta_m|$ < 1% of the magnitude of the magnetic dipole moment of the radially inner partial coil system *(C1)*.

5. Method for operating a magnet assembly according to any one of the preceding claims, **characterized in that** the magnet assembly is part of an apparatus for high-resolution magnetic resonance spectroscopy.

6. Method for operating a magnet assembly according to any one of the preceding claims, **characterized in that** of the at least one current path *(P1, ..., Pn)* at least one comprises a device for limiting the induced current.

7. Method for operating a magnet assembly according to any one of the preceding claims, **characterized in that** of the at least one current path *(P1, ..., Pn)* at least one is bridged by a superconducting switch and the magnet assembly comprises a means for supplying current to this current path.

8. Method for operating a magnet assembly according to any one of the preceding claims, **characterized in that** at of the at least one superconductingly short-circuited current path *(P1, ..., Pn)* at least one is also part of a device, which compensates for external magnetic field fluctuations in the operating state of the magnet assembly.

9. Method for operating a magnet assembly according to any one of the preceding claims, **characterized in that** of the at least one current path *(P1, ..., Pn)* at least one is thermally decoupled from the actively shielded superconducting magnet coil system *(M)*, preferably such that the amount of heat transferred to this current path in case of a quench of the actively shielded superconducting magnet coil system *(M)* is not more than fifty percent of the amount of heat required to trigger a quench in this current path.

10. Method for operating a magnet assembly according to any one of the preceding claims, **characterized in that** of the at least one current path *(P1, ..., Pn)* at least one comprises magnet coils having a radius which is at least 90% of the radius of the outermost coils of the actively shielded superconducting magnet coil system *(M)*.

11. Method for operating a magnet assembly according to any one of the preceding claims, **characterized in that** of the at least one current path *(P1, ..., Pn)* at least one comprises coils which are wound on a coil former which also carries coils of the radially outer partial coil system *(C2)* of the actively shielded superconducting magnet coil system *(M)*.

12. Method for operating a magnet assembly according to any one of the preceding claims, **characterized in that** of the at least one current path *(P1, ..., Pn)* at least one generates a magnetic field in the operating state which is asymmetrical relative to the plane which is perpendicular to the z axis and intersects same at *z* = 0.

**Revendications**

1. Procédé pour faire fonctionner un dispositif magnétique destiné à générer un champ magnétique *(H)* en direction d'un axe *z* dans un volume de travail *(AV)* disposé sur l'axe *z* autour de *z* = 0 avec un système de bobines magnétiques supraconductrices *(M)* blindé activement et avec au moins un chemin de courant *(P1, ..., Pn)* d'un système de bobines supplémentaire (C3), fermé sur lui-même de manière supraconductrice dans l'état de fonctionnement, le système de bobines magnétiques supraconductrices *(M)* blindé activement comprenant un sous-système de bobines radialement intérieur *(C1)* et un sous-système de bobines radialement extérieur (C2), lesquels sont disposés coaxialement l'un à l'autre et dont les moments magnétiques dipolaires présentent des signes opposé dans l'état de fonctionnement et diffèrent l'un de l'autre en valeur absolue de $\Delta_m$ avec $|\Delta_m|$ < 2,5 % de la valeur absolue du moment magnétique dipolaire du sous-système de bobines radialement intérieur *(C1)*,
**caractérisé en ce**
**que** parmi lesdits au moins un chemins de courant *(P1, ..., Pn)*, au moins un *(Pj$_1$, ..., Pj$_m$)* présente avec le premier sous-système de bobines radialement intérieur *(C1)* et au moins un *(Pk$_1$, ..., Pk$_p$)* avec le deuxième sous-système de bobines radialement extérieur *(C2)* du système de bobines magnétiques supraconductrices *(M)* blindé activement un couplage inductif différent de zéro $L_{C1\Leftrightarrow pj_1}, ..., L_{C1\Leftrightarrow Pj_m}$, respectivement $L_{C2\Leftrightarrow Pk_1}, ..., L_{C2\Leftrightarrow Pk_p}$, $L_{C1}$, $L_{C2}$, $L_{Pj_1}, ...,$ $L_{Pj_m}$ et $L_{Pk_1}, ..., L_{Pk_p}$ désignant les inductances propres des sous-système de bobines *(C1)* et *(C2)* du système de bobines magnétiques supraconductrices *(M)* blindé activement, respectivement les inductances propres des chemins de courant *(Pj$_1$, ..., Pj$_m$)* et *(Pk$_1$, ..., Pk$_p$)*,
**que** ledit au moins un chemin de courant *(P1, ..., Pn)* est court-circuité de manière supraconductrice au moins temporairement pendant la charge du système de bobines magnétiques supraconductrices *(M)* blindé activement, tous les chemins de courant *(P1, ..., Pn)* dudit au moins un chemin de courant *(P1, ..., Pn)* étant conçus de manière que les courants qui y sont induits par suite du processus de charge du système de bobines magnétiques supraconductrices *(M)* génèrent au total un moment magnétique dipolaire dont la valeur absolue atteint au moins 0,1 % de la valeur absolue du moment magnétique dipolaire du sous-système de bobines radialement extérieur *(C2)*

chargé, en sorte que l'allure du champ de fuite à l'extérieur du dispositif magnétique est optimisée.

**2.** Procédé selon la revendication 1, **caractérisé en ce que** les coefficients de couplage correspondants

$$K_{1,j_1} = \frac{L_{C1 \Leftrightarrow Pj_1}}{\sqrt{L_{C1}L_{Pj_1}}}, ..., K_{1,j_m} = \frac{L_{C1 \Leftrightarrow Pj_m}}{\sqrt{L_{C1}L_{Pj_m}}}$$

sont supérieurs à 0,01 et

$$K_{2,k_1} = \frac{L_{C2 \Leftrightarrow Pk_1}}{\sqrt{L_{C2}L_{Pk_1}}}, ..., K_{2,k_p} = \frac{L_{C2 \Leftrightarrow Pk_p}}{\sqrt{L_{C2}L_{Pk_p}}}$$

sont inférieurs à -0,01.

**3.** Procédé pour faire fonctionner un dispositif magnétique selon l'une des revendications précédentes, **caractérisé en ce que** lors de la conception des sous-système de bobines ($C1$) et ($C2$) et dudit au moins un chemin de courant ($P1, ..., Pn$), le nombre et la position des enroulements de fil ont été choisis de façon que parmi lesdits au moins un chemins de courant ($P1, ..., Pn$), au moins un ($Pi_1, ..., Pi_q$) soit essentiellement découplé inductivement du système de bobines magnétiques supraconductrices ($M$) blindé activement, en particulier de façon que pour chacun de ces chemins de courant ($Pi_1, ..., Pi_q$) le couplage inductif avec le sous-système de bobines radialement intérieur ($C1$) soit essentiellement opposé et égal au couplage inductif avec le sous-système de bobines radialement extérieur (C2).

**4.** Procédé pour faire fonctionner un dispositif magnétique selon l'une des revendications précédentes, **caractérisé en ce que** $|\Delta_m|$ < 1 % de la valeur absolue du moment magnétique dipolaire du sous-système de bobines radialement intérieur ($C1$).

**5.** Procédé pour faire fonctionner un dispositif magnétique selon l'une des revendications précédentes, **caractérisé en ce que** le dispositif magnétique fait partie d'un appareillage de spectroscopie de résonance magnétique nucléaire à haute résolution.

**6.** Procédé pour faire fonctionner un dispositif magnétique selon l'une des revendications précédentes, **caractérisé en ce que** parmi lesdits au moins un chemins de courant ($P1, ..., Pn$), au moins un présente un dispositif de limitation du courant qui y est induit.

**7.** Procédé pour faire fonctionner un dispositif magnétique selon l'une des revendications précédentes, **caractérisé en ce que** parmi lesdits au moins un chemins de courant ($P1, ..., Pn$), au moins un est court-circuité par un commutateur supraconducteur et que le dispositif magnétique comprend un dispositif pour l'alimentation en courant de ce chemin de courant.

**8.** Procédé pour faire fonctionner un dispositif magnétique selon l'une des revendications précédentes, **caractérisé en ce que** parmi lesdits au moins un chemins de courant ($P1, ..., Pn$) court-circuités de manière supraconductrice, au moins un fait en plus partie d'un dispositif qui, dans l'état de fonctionnement, sert dans le dispositif magnétique à compenser les fluctuations de champs magnétiques externes.

**9.** Procédé pour faire fonctionner un dispositif magnétique selon l'une des revendications précédentes, **caractérisé en ce que** parmi lesdits au moins un chemins de courant ($P1, ..., Pn$), au moins un est découplé thermiquement du système de bobines magnétiques supraconductrices ($M$) blindé activement, de préférence de façon que la quantité de chaleur transmise à ce chemin de courant en cas de quench du système de bobines magnétiques supraconductrices ($M$) blindé activement ne soit pas supérieure à cinquante pour cent de la quantité de chaleur qui est nécessaire pour déclencher un quench dans ce chemin de courant.

**10.** Procédé pour faire fonctionner un dispositif magnétique selon l'une des revendications précédentes, **caractérisé en ce que** parmi lesdits au moins un chemins de courant (*P1*, ..., *Pn*), au moins un comprend des bobines magnétiques qui ont un rayon au moins égal à 90 % du rayon des bobines les plus extérieures du système de bobines magnétiques supraconductrices (*M*) blindé activement.

**11.** Procédé pour faire fonctionner un dispositif magnétique selon l'une des revendications précédentes, **caractérisé en ce que** parmi lesdits au moins un chemins de courant (*P1*, ..., *Pn*), au moins un comprend des bobines qui sont enroulées sur une carcasse de bobine qui sert aussi de support aux bobines du sous-système de bobines radialement extérieur (C2) du système de bobines magnétiques supraconductrices (*M*) blindé activement.

**12.** Procédé pour faire fonctionner un dispositif magnétique selon l'une des revendications précédentes, **caractérisé en ce que** parmi lesdits au moins un chemins de courant (*P1*, ..., *Pn*), au moins un génère, dans l'état de fonctionnement, un champ magnétique asymétrique par rapport au plan qui est perpendiculaire à l'axe *z* et coupe celui-ci en *z* = 0.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6265960 B
- WO 0052490 A
- EP 1213591 A2